Europäisches Patentamt

European Patent Office

Office européen des brevets

(11) Veröffentlichungsnummer: **0 276 749**
**A1**

(12) **EUROPÄISCHE PATENTANMELDUNG**

(21) Anmeldenummer: 88100794.2

(22) Anmeldetag: 20.01.88

(51) Int. Cl.⁴: **H01L 31/16** , H01L 31/12

(30) Priorität: 26.01.87 DE 3702231

(43) Veröffentlichungstag der Anmeldung:
03.08.88 Patentblatt 88/31

(84) Benannte Vertragsstaaten:
BE DE FR GB

(71) Anmelder: **Siemens Aktiengesellschaft Berlin
und München
Wittelsbacherplatz 2
D-8000 München 2(DE)**

(72) Erfinder: **Bierlmaier, Johann
Rimstinger Strasse 2
D-8000 München 80(DE)**

(54) **Optoelektronisches Koppelelement.**

(57) Das optoelektronische Koppelelement hat ein lichtaussendendes Halbleiterbauelement (1) und eine lichtempfindliche Anordnung (2), die auf sich gegenüberliegenden Kontaktzungen (3a, 9a) von in einer Ebene liegenden Anschlußleitungen (3, 9) angeordnet sind. Diese Kontaktzungen (3a, 9a) sind in entgegengesetzter Richtung zur Ebene der Anschlußleitungen (3, 9) abgewinkelt.

## FIG 2

## Optoelektronisches Koppelelement

Die Erfindung betrifft ein optoelektronisches Koppelelement,
das folgende Merkmale aufweist:

a) ein lichtaussendendes Halbleiterelement,

b) eine lichtempfindliche Anordnung,

c) zwei in einer Ebene parallel zueinanderliegende und aus einem gemeinsamen Metallband hergestellte Anschlußgruppen mit jeweils parallel zueinander angeordneten Anschlußleitungen mit Kontaktzungen,

d) die Kontaktzungen der Anschlußleitungen jeder Anschlußgruppe sind gegenüber den Kontaktzungen der Anschlußleitungen der anderen Anschlußgruppe angeordnet,

e) das lichtaussendende Halbleiterbauelement ist mit den Anschlußleitungen der einen Anschlußgruppe elektrisch verbunden und auf der Kontaktzunge einer dieser Anschlußleitungen angeordnet,

f) die lichtempfindliche Anordnung ist mit Anschlußleitungen der anderen Anschußgruppe elektrisch verbunden und auf der dem lichtaussendenden Halbleiterbauelement gegenüberliegenden Kontaktzunge dieser Anschlußleitungen angeordnet,

g) die lichtempfindliche Fläche der lichtempfindlichen Anordnung verläuft parallel zur Ebene der Kontaktzunge,

h) die lichtempfindliche Anordnung und das lichtaussendende Halbleiterbauelement sind durch ein lichtdurchlässiges Medium miteinander verbunden.

Ein solches optoelektronische Koppelelement ist beispielsweise in der DE-PS 29 50 649 beschrieben. Dort sind die mit Kontaktzungen versehenen Anschlußleitungen aus einem dünnen und planparallelen Metallblech ausgestanzt. Eine Leuchtdiode und ein lichtempfindliches Halbleiterbauelement sind jeweils auf den sich gegenüberliegenden Kontaktzungen befestigt. Außerdem sind die sich gegenüberliegenden Kontaktzungen zur Ebene der Anschlußleitungen um annähernd 45° in gleicher Richtung abgewinkelt. Die Ebene der Kontaktzunge und die Oberfläche der auf dieser Kontaktzunge montierten lichtempfindlichen Anordnung verlaufen parallel. Die Leuchtdiode ist so ausgebildet, daß die Lichtstrahlung parallel zur Ebene der zur Befestigung der Leuchtdiode dienenden Kontaktzunge erfolgt. In der DE-PS 29 50 649 wird diese Art von Leuchtdiode als sogenannter horizontalstrahlender Typ bezeichnet, d.h., daß das vom PN-Übergang ausgesandte Licht die Leuchtdiode in Richtung des PN-Übergangs durch eine lichtabstrahlende Stirnfläche verläßt. Durch die um 45° abgewinkelten Kontaktzungen wird gewährleistet, daß die lichtabstrahlende Stirnfläche der Leuchtdiode horizontalstrahlenden Typs parallel zur lichtempfindlichen Oberfläche des lichtempfindlichen Halbleiterbauelements liegt, so daß das abgestrahlte Licht rechtwinklig auf das lichtempfindliche Halbleiterbauelement auftrifft und damit kein Reflektor notwendig ist.

Das in der DE-PS 29 50 649 beschriebene optoelektronische Koppelelement hat aber den Nachteil, daß nur eine solche Leuchtdiode verwendet werden kann, die an ihrer Stirnfläche Licht abstrahlt. Damit ist aber die lichtaussendende Fläche dieser Leuchtdiode im Vergleich zu einer Leuchtdiode gleicher Abmessungen, die jedoch an ihrer Hauptfläche Licht emittiert, kleiner und folglich der Wirkungsgrad schlechter. Ein solches Halbleiterbauelement, das mit seiner einen Hauptfläche auf der Kontaktzunge sitzt und damit für eine gute Auflagefläche sorgt, und an der der Auflagefläche gegenüberliegenden Hauptfläche Licht abstrahlt, kann bei diesem bekannten optoelektronischen Koppelelement nicht verwendet werden, weil dann das Licht nicht mehr senkrecht auf die lichtempfindliche Oberfläche des lichtempfindlichen Halbleiterbauelementes treffen würde, sondern parallel dazu verläuft.

Es sind andere optoelektronische Koppelelemente bekannt, die solche lichtaussendenden Halbleiterbauelemente aufweisen, deren lichtabstrahlende Oberfläche parallel zur als Hauptfläche dienenden Montagefläche verläuft und daß durch dieses Halbleiterbauelement emittierte Licht etwa senkrecht auf die lichtempfindliche Oberfläche eines lichtempfindlichen Halbleiterbau element trifft. So ist z.B. in der DE-AS 24 31 375 ein Reflektor vorgesehen, der über den parallel zueinander angeordneten lichtaussendenden und lichtempfindlichen Halbleiterbauelementen angeordnet ist. Der Nachteil einer solchen Anordnung liegt in der durch Streu-und Absorptionsverluste und dem relativ langen Lichtweg bedingten geringen Kopplungsgrad.

Andererseits ist aus der DE-OS 21 18 391 ein optoelektronisches Koppelelement bekannt, das aus zwei mit der Leuchtdiode und dem lichtempfindlichen Halbleiterbauelement versehenen Trägern besteht, welche bei der Herstellung des optoelektronischen Koppelelements einander gegenüber in eine Gußschale gebracht werden, dort von einem lichtdurchlässigen Medium eingegossen und nach dessen Aushärtung wieder aus der Gußschale entfernt werden. Ein Nachteil dieses optoelektronischen Koppelelementes ist vor allem darin zu sehen, daß zwei verschiedene Träger in zwei Arbeitsgängen hergestellt werden müssen, und daß in weiterer zwei Arbeitsgängen diese Träger mit den Halbleiterbauelementen versehen werden müssen, und daß anschließend die Träger mit den auf ihnen befestigten Halbleiterbauelementen exakt justiert werden müssen.

Der Erfindung liegt die Aufgabe zugrunde, ein optoelektronisches Koppelelement mit einem an seiner Hauptfläche lichtabstrahlenden Halbleiterbauelement zu bilden, daß einen guten Wirkungsgrad aufweist und einfach herzustellen ist.

Diese Aufgabe wird durch folgende Merkmale gelöst:

i) das lichtaussendende Halbleiterbauelement ist derart ausgebildet, daß die Lichtstrahlung senkrecht zur Ebene der Kontaktzunge erfolgt,

j) die Kontaktzungen der das Licht aussendenden Halbleiterbauelement tragenden Anschlußgruppe sind zur Ebene der Anschlußleitungen in eine Richtung abgewinkelt und die Kontaktzunge der die lichtempfindliche Anordnung tragenden Anschlußgruppe sind in die andere Richtung abgewinkelt,

k) das lichtaussendende Halbleiterbauelement und die lichtempfindliche Anordnung sind auf den sich gegenüberliegenden Flächen der abgewinkelten Kontaktzungen angeordnet.

Das optoelektronische Koppelelement gemäß der Erfindung hat einen guten Wirkungsgrad und bedarf keines teueren Justieraufwandes, wie dies z.B. bei Zweibandkonzepten der Fall ist, bei denen zunächst das lichtaussendende Halbleiterbauelement und die lichtempfindliche Anordnung auf jeweils getrennten Trägerkörpern montiert werden müssen und anschließend diese beiden Träger exakt aufeinander ausgerichtet und fixiert werden müssen. Außerdem ist die Montage des optoelektronischen Koppelelements leicht durchzuführen. Aus einem Metallband wird zunächst ein Rahmen mit zusammenhängenden parallelen Anschlußleitungen mit Kontaktzungen gebildet. Dann wird das lichtempfindliche Halbleiterbauelement auf eine Kontaktzunge montiert, um mit den Anschlußleitungen verbunden zu werden. Danach wird der Rahmen um 180° umgedreht und die lichtempfindliche Anordnung auf den dafür vorgesehenen Kontaktzungen aufgebracht und elektrisch mit den Anschlußleitungen verbunden. Dies kann selbstverständlich auch in umgekehrter Reihenfolge geschehen. Damit ist ein leichter Zugang der Befestigungsvorrichtung für die Bauelemente sowie z. B. ein leichtes Bonden der Anschlußdrähte gewährleistet, der nicht durch einen bestimmten Öffnungwinkel der Kontaktzungen eingeengt ist. Erst anschließend werden die Kontaktzungen abgewinkelt.

Die Erfindung wird anhand von drei Figuren näher erläutert. Es zeigen:

FIG 1 einen aus einem Metallband hergestellten Rahmen mit zusammenhängenden parallelen Anschlußleitungen, und

FIG 2 ein erfindungsgemäßes optoelektronisches Koppelelement, und

FIG 3 verschiedene Möglichkeiten zur Anordnung der Anschlußleitungen.

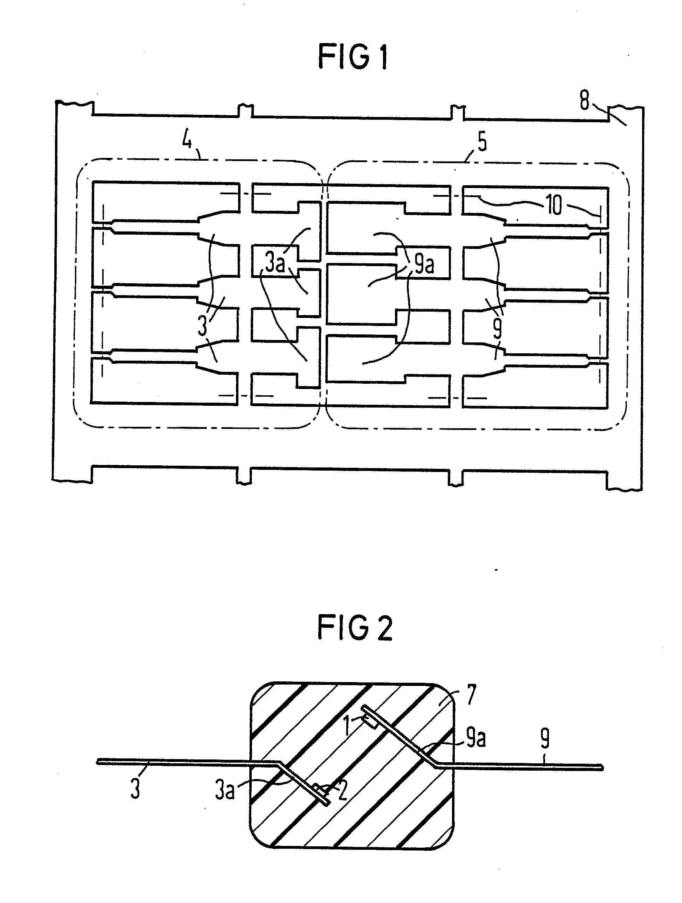

Der in FIG 1 dargestellte Rahmen mit zusammenhängenden parallelen Anschlußleitungen 9, 3 ist aus einem einzigen Metallband z.B. durch Ausstanzen hergestellt. Die Anschlußleitungen 9, 3 sind in zwei Anschlußgruppen 5, 4 so aufgeteilt, daß die Kontaktzungen 9a der Anschlußleitungen 9 gegenüber der Kontaktzungen 3a der Anschlußleitungen 3 angeordnet sind. Der Rahmen 8 und die zusammenhängenden parallelen Anschlußleitungen 9, 3 sind vorzugsweise so ausgebildet, daß sie leicht voneinander zu trennen sind. Die Trennungslinien 10 sind in der FIG 1 dargestellt.

FIG 2 zeigt ein erfindungsgemäßes optoelektronisches Koppelelement im Schnitt. Die Anschlußleitungen 3 und 9 liegen in einer Ebene. Die Anschlußleitungen 3 weisen Kontaktzungen 3a auf, die zur Ebene der Anschlußleitungen 3, 9 in einer Rich-tung, z. B. nach unten abgewinkelt sind. Die Kontaktzungen 9a der Anschlußleitungen 9 sind dagegen in entgegengesetzter Richtung, also nach oben so abgewinkelt, daß sich die Kontaktzungen 9a, 3a etwa parallel gegenüberstehen. Auf der Oberseite der Kontaktzunge 3a ist eine lichtempfindliche Anordnung 2 und auf der Unterseite der Kontaktzunge 9a ein lichtaussendendes Halbleiterbauelement 1 angeordnet, bzw. umgekehrt. Die lichtempfindliche Oberfläche der lichtempfindlichen Anordnung 2 verläuft parallel zur Ebene der Kontaktzunge 3a. Das lichtaussendende Halbleiterbauelement 1, welches z.B. ein Fototransistor sein kann, ist derart ausgebildet, daß die Lichtstrahlung senkrecht zur Ebene der Kontaktzunge 9a erfolgt und damit mindestens etwa senkrecht auf die lichtempfindliche Oberfläche der lichtempfindlichen Anordnung 2 auftrifft. Das lichtaussendende Halbleiterbauelement 1 ist derart ausgebildet, daß die Lichtstrahlung senkrecht zur Ebene der Kontaktzunge 9a erfolgt. Das lichtaussendende Halbleiterbauelement 1 ist auf der Kontaktzunge 9a angeordnet, die der Kontaktzunge 3a mit der lichtempfindlichen Anordnung 2 gegenüberliegt. Durch diesen Aufbau ist gewährleistet, daß die lichtabstrahlende Oberfläche des lichtaussendenden Halbleiterbauelementes 1 auf die lichtempfindliche Oberfläche der lichtempfindlichen Anordnung 2 ausgerichtet ist. Die lichtempfindliche Anordnung 2 und das lichtaussendende Halbleiterbauelement 1 sind durch ein lichtdurchlässiges Medium 7 miteinander verbunden. Die Kontaktzungen 9a, 3a, das lichtaussendende Halbleiterbauelement 1, die lichtempfindliche Anordnung 2 und das lichtdurchlässige Medium 7 sind vorzugsweise von einem lichtundurchlässigen Kunststoffgehäuse - das aus Gründen der besseren Übersichtlichkeit in der FIG 2 nicht dargestellt ist - umgeben. Die aus diesem lichtundurchlässigen Kunststoffgehäuse herausragenden Teile der Anschlußleitungen können, nachdem sie vom Rahmen 8 getrennt worden sind, in die für den Anwender notwendige Lage gebogen werden.

Die lichtempfindliche Anordnung 2 des erfindungsgemäßen optoelektronischen Koppelements ist nicht auf ein einziges lichtempfindliches Halbleiterbauelement beschränkt. Vielmehr kann die lichtempfindliche Anordnung 2 auch aus mehreren, z.B. zwei lichtempfindlichen Halbleiterbauelementen bestehen. Diese z.B. zwei lichtempfindlichen Halbleiterbauelemente können dann entweder isoliert auf einer Kontaktzunge 3a oder auf zwei getrennten Kontaktzungen 3a angeordnet werden. Diese lichtempfindlichen Halbleiterbauelemente werden dann in geeigneter Weise mit den Anschlußleitungen 3 verbunden.

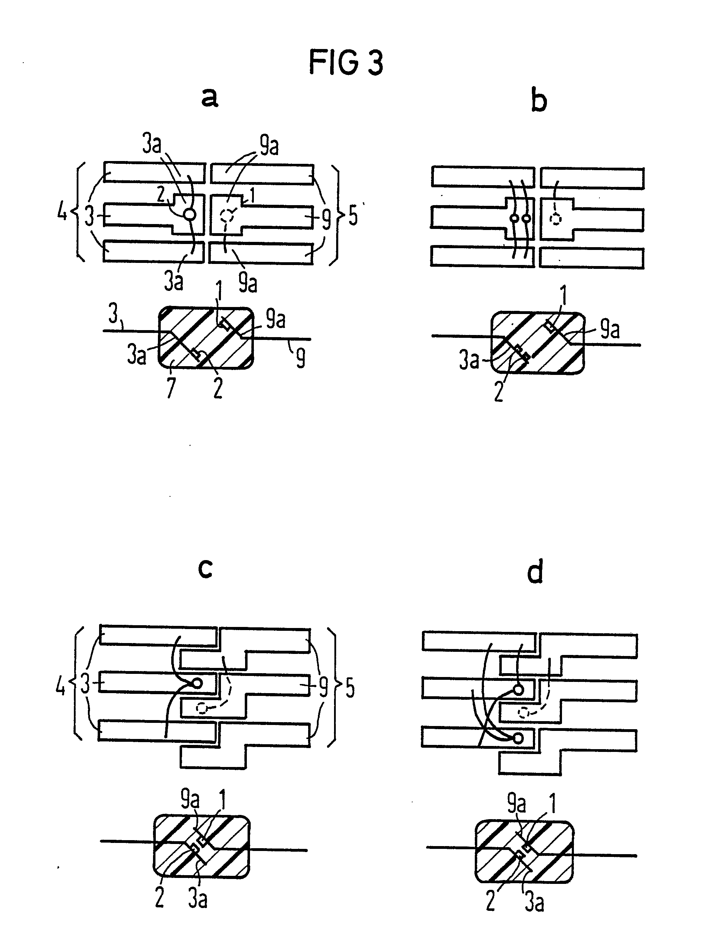

In FIG 3 sind vier verschiedene Möglichkeiten dargestellt, wie die Anschlußleitungen 3, 9 angeordnet werden können. Die Anschlußleitungen 3, die für die Aufnahme der lichtempfindlichen Anordnung 2 vorgesehen sind, sind zu einer Anschlußgruppe 4 zusammengefaßt und die Anschlußleitungen 9, die für die Aufnahme des lichtaussendenden Halbleiterbauelementes 1 bestimmt sind, zu einer Anschlußgruppe 5. Dabei ist die lichtempfindliche Anordnung 2 z.B. auf der Oberseite einer Kontaktzunge 3a befestigt und mit den Anschlußleitungen 3 in geeigneter Weise elektrisch verbunden. Das lichtaussendende Halbleiterelement 1 ist auf der Unterseite einer Kontaktzunge 9a befestigt und ebenfalls in geeigneter Weise mit den Anschlußleitungen 9 elektrisch verbunden. Die Anordnung der Anschlußleitungen 3, 9 in FIG 3a entspricht im wesentlichen der Darstellung in FIG 1. Ist das lichtaussendende Halbleiterbauelement 1 z.B. eine Fotodiode, so ist in FIG 1 der eine Pol der Fotodiode elektrisch mit der Anschlußleitung 9 verbunden, auf der auch die Fotodiode montiert ist, und der andere Pol mit einer nebenliegenden Anschlußleitung 9. Auf der Oberseite der die Fotodiode tragenden Kontaktzunge 9a gegenüberliegenden Kontaktzunge 3a ist z.B. ein lichtempfindlicher Foto transistor angeordnet. Dieser lichtempfindliche Fototransistor ist z.B. elektrisch mit der ihn tragenden Kontaktzunge 3a verbunden. Die übrigen notwendigen Anschlüsse dieses lichtempfindlichen Fototransistors sind mit den notwendigen Anschlußleitungen 3 der Anschlußgruppe 4 verbunden. In FIG 3a unten ist die dazugehörige Seitenansicht dargestellt.

FIG 3b unterscheidet sich von FIG 3a lediglich dadurch, daß als lichtempfindliche Anordnung 2 zwei lichtempfindliche Halbleiterbauelemente verwendet werden. Diese zwei lichtempfindlichen Halbleiterbauelemente sind isoliert voneinander auf der das lichtaussendende Halbleiterbauelement tragenden Kontaktzunge 9a gegenüberliegende Kontaktzunge 3a befestigt. Diese zwei lichtempfindlichen Halbleiterbauelemente sind dann in geeigneter Weise wieder mit den Anschlußleitungen 3 der Anschlußgruppe 4 verbunden. In FIG 3b ist zusätzlich die Seitenansicht dieser Anordnung dargestellt. Die beiden lichtempfindlichen Halbleiterbauelemente sind auf der Kontaktzunge 3a so angeordnet, daß sie mindestens etwa gleich stark von dem Licht des lichtaussendenden Halbleiterbauelementes 1 bestrahlt werden.

In FIG 3c ist eine weitere Anordnung der Anschlußleitungen 3, 9 dargestellt. Die Lage der Anschlußleitungen 3, 9 unterscheidet sich durch die in FIG 3a und 3b dargestellten Anordnungen dadurch, daß die Anschlußleitungen 3 der Anschlußgruppe 4 und die Anschlußleitungen 9 der Anschußgruppe 5 ineinander verzahnt sind. Die lichtempfindliche Anordnung 2 und das lichtaussendende Halbleiterbauelement 1 sind auf den sich gegenüberliegenden Kontaktzungen 3a, 9a angeordnet. Diese Anordnung 3c hat den Vorteil, daß die abgewinkelten Kontaktzungen 3a, 9a näher beieinanderliegen können.

In FIG 3d ist eine Anordnung dargestellt, wie sie der Anordnung nach FIG 3c entspricht. Der Unterschied besteht jedoch darin, daß die lichtempfindliche Anordnung 2 aus zwei lichtempfindlichen Halbleiterbauelemente besteht. Diese zwei lichtempfindlichen Halbleiterbauelemente sind auf zwei benachbarten Kontaktzungen 3a der Anschlußleitungen 3 der Anschußgruppe 4 angeordnet. Das lichtaussendende Halbleiterbauelement 1 ist auf der Kontaktzunge 9a angeordnet, die zwischen diese zwei Kontaktzungen 3a ragt. Außerdem ist in FIG 3d die zu dieser Darstellung angeordnete Seitenansicht dargestellt.

Es ist hier noch anzumerken, daß es zweckmäßig ist, das lichtdurchlässige Medium 7 und das lichtundurchlässige Kunststoffgehäuse derart auszuwählen, daß ihre Wärmeausdehnungskoeffizienten annähernd gleich sind. Dies hat den Vorteil, daß bei Temperaturbelastungen keine oder nur geringe Scherkräfte auftreten und keine Beschädigung des optoelektronischen Koppelements auftreten. Als besonders günstig hat sich z.B. Quarzgutmehl erwiesen.

## Ansprüche

1. Optoelektronisches Koppelemente, das folgende Merkmale aufweist:

    a) ein lichtaussendendes Halbleiterbauelement (1),

    b) eine lichtempfindliche Anordnung (2),

c) zwei in einer Ebene parallel zueinanderliegende und aus einem gemeinsamen Metallband hergestellte Anschlußgruppen (4, 5) mit jeweils parallel zueinander angeordneten Anschlußleitungen (3, 9) mit Kontaktzungen (3a, 9a),

d) die Kontaktzungen (3a, 9a) der Anschlußleitungen (3, 9) jeder Anschlußgruppe (4, 5) sind gegenüber den Kontaktzungen (3a, 9a) der Anschlußleitungen (3, 9) der anderen Anschlußgruppe (4, 5) angeordnet,

e) das lichtaussendende Halbleiterbauelement (1) ist mit den Anschlußleitungen (9) der einen Anschlußgruppe (5) elektrisch verbunden und auf der Kontaktzunge (9a) einer dieser Anschlußleitungen (9) angeordnet,

f) die lichtempfindliche Anordnung (2) ist mit Anschlußleitungen (3) der anderen Anschlußgruppe (4) elektrisch verbunden und auf der dem lichtaussendenden Halbleiterbauelement (1) gegenüberliegenden Kontaktzunge (3a) dieser Anschlußleitungen (3) angeordnet,

g) die lichtempfindliche Fläche der lichtempfindlichen Anordnung (2) verläuft parallel zur Ebene der Kontaktzunge (3a),

h) die lichtempfindliche Anordnung (2) und das lichtaussendende Halbleiterbauelement (1) sind durch ein lichtdurchlässiges Medium (7) miteinander verbunden,

**gekennzeichnet** durch folgende Merkmale:

i) das lichtaussendende Halbleiterbauelement (1) ist derart ausgebildet, daß die Lichtstrahlung senkrecht zur Ebene der Kontaktzunge (9a) erfolgt,

j) die Kontaktzungen (9a) der das Licht aussendenden Halbleiterbauelement (1) tragenden Anschlußgruppe (5) sind zur Ebene der Anschlußleitungen (9, 3) in eine Richtung abgewinkelt und die Kontaktzunge (3a) der die lichtempfindliche Anordnung (2) tragenden Anschlußgruppe (4) sind in die andere Richtung abgewinkelt,

k) das lichtaussendende Halbleiterbauelement (1) und die lichtempfindliche Anordnung (2) sind auf den sich gegenüberliegenden Flächen der abgewinkelten Kontaktzungen (3a, 9a) angeordnet.

2. Optoelektronisches Koppelelement nach Anspruch 1, **dadurch gekennzeichnet,** daß die lichtempfindliche Anordnung (2) aus mindestens zwei lichtempfindlichen Halbleiterbauelementen besteht.

3. Optoelektronisches Koppelelement nach Anspruch 2, **dadurch gekennzeichnet,** daß jedes lichtempfindliche Halbleiterbauelement auf einer eigenen Kontaktzunge (3a) angeordnet ist.

4. Optoelektronisches Koppelelement nach Anspruch 2, **dadurch gekennzeichnet,** daß jedes lichtempfindliche Halbleiterbauelement auf ein und derselben Kontaktzunge (3a) isoliert zueinander angeordnet ist.

## FIG 1

## FIG 2

0 276 749

# FIG 3

Europäisches
Patentamt

EUROPÄISCHER RECHERCHENBERICHT

Nummer der Anmeldung

EP 88 10 0794

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | EP-A-0 206 325 (HEWLETT-PACKARD CO.) * Seiten 1-7; Ansprüche 23,24,29; Figuren 3,5-11 * --- | 1 | H 01 L 31/16 H 01 L 31/12 |
| Y | US-A-3 839 782 (M.L. LINCOLN) * Spalte 4, Zeile 46 - Spalte 8, Zeile 11; Figuren 1-5; Anspruch 1 * --- | 1 | |
| A | DE-A-2 555 492 (STANDARD ELECTRIC LORENZ AG) * Insgesamt * --- | 1,2 | |
| A | PATENT ABSTRACTS OF JAPAN, Band 3, Nr. 6 (E-85), 22. Januar 1979, Seite 37 E 85; & JP-A-53 133 384 (TATEISHI DENKI K.K.) 21-11-1978 * Insgesamt * --- | 1 | |
| A | PATENT ABSTRACTS OF JAPAN, Band 9, Nr. 230 (E-343)[1953], 17. September 1985; & JP-A-60 84 889 (NIPPON DENKI K.K.) 14-05-1985 * Insgesamt * --- | 1 | |
| A | US-A-3 808 673 (M.L. BOTTINI) * Spalte 2, Zeile 54 - Spalte 6, Zeile 22; Figuren 1-6 * --- | 1 | |
| D,A | DE-A-2 950 649 (TOKYO SHIBAURA DENKI K.K.) --- | | |
| A | GB-A-2 107 929 (GENERAL ELECTRIC CO.) ----- | | |

RECHERCHIERTE SACHGEBIETE (Int. Cl.4)

H 01 L

Der vorliegende Recherchenbericht wurde für alle Patentansprüche erstellt

| Recherchenort | Abschlußdatum der Recherche | Prüfer |
|---|---|---|
| DEN HAAG | 07-03-1988 | VISENTIN A. |